# EUROPEAN PATENT APPLICATION

(11) **EP 1 009 207 A2**
(43) Date of publication of application: **14.06.2000**
(21) Application number: 99309843.3
(22) Date of filing: 07.12.1999
(51) Int. Cl.: H05K 5/04, H05K 7/14

(54) **A housing for electrical equipment**

(30) Priority: 07.12.1998 GB 9826837
(71) Applicant: Alstom UK Limited, Rugby, Warwickshire CV21 1TB (GB)
(72) Inventor: Bentall, Simon William, St. Albans, Hertfordshire AL3 4DL (GB)
(74) Representative: Spall, Christopher John

(57) **Abstract**

A housing (1) is disclosed for electrical equipment comprising a casing (2, 3, 4, 5) and a door (8) of which at least a part is made of resilient material. The door (8) is adapted to pivot about a hinge along one edge relative to the casing and engages the casing by resilient deformation of the door (8). The resilient door is hinged to a second door (9) which in turn is hinged to the frame (2, 3, 4, 5) to provide a two-door entry.

## Description

This invention relates to improvements in housings for electrical equipment, and in particular but not exclusively to housings for both low voltage and high voltage electrical circuitry such as a motor controller.

It is known to provide medium to heavy duty electrical circuitry within a range of standard sized housings. The choice of the size of housing depends on the rating of the electrical circuitry which it is to contain, often due to the need to dissipate adequate heat.

For many electrical circuits, such as a heavy duty motor controller for a.c. drives, a typical user may have several units controlling several electrical motors in a process. It is therefore desirable to make the housing as compact as possible so as to minimise space requirements. The housing should also be attractive and provide convenient access to its contents.

According to the present invention, we provide housing for electrical equipment comprising a casing and a door of which at least a part is made of resilient material, the door being adapted to pivot about a hinge along one edge relative to the casing for movement between an open and a closed position, said door being adapted to engage the casing when it is closed position and adapted to be disengaged and moved to an open position by resilient deformation of the door and characterised in that the resilient door is hinged to a second door which in turn is hinged to the frame to provide a two-stage entry.

By providing a hinged resilient door, the need for a separate contact, retainer or lock to engage the casing is eliminated, simplifying the design.

Preferably, the door comprises a one piece plastics component. It may conveniently be extruded or otherwise moulded. The whole door may therefore be constructed from a resilient material.

The provision of two doors provides a two-stage entry to the housing. The two doors may sit side by side when they are both closed, i.e. be in parallel.

The door may be extruded as a single piece of indefinite length. It can then be cut down to the appropriate length depending on the size of the casing to which it is to be incorporated.

Preferably the casing comprises a pressed metal frame formed at least partially from sheet metal. This is very cheap and simple to produce. The frame may also serve as a chassis for one or more of the electrical components to be held in the frame. It may be adapted to enable the frame to be rack mounted.

The resilient door preferably has a substantially U-shaped cross section with a substantially flat elongated base portion. One side of the U-shape may be hinged to a first side wall of the frame, the other side resiliently engaging with an inner face of the second side wall of the frame.

An end of the second side wall of the frame may be folded back on itself to avoid a sharp edge. A flange formed on the unhinged side of the U-shaped door section may engage behind the folded back portion of the frame to hold the door latched in its closed position.

One advantage of providing a sheet metal frame and a resilient door is that it enables a row of similar units to be placed side by side with no space required between the side panels to open the door. The walls of the frame are only thin sheet metal, producing a narrow structure.

In a first stage, the resilient door can be deformed and opened without tools to access a first portion of the housing. This portion may contain, for example, low voltage equipment.

In a second stage, the second door may be opened to gain access to a further part of the housing. This may contain high voltage equipment. If so, it is desirable that the second door can only be opened using suitable tools (i.e. tool access) to meet safety requirements.

In an especially preferred arrangement, the first door must be opened to gain access to a lock mechanism (such as a key-operated lock or a slot headed bolt) for the second door. Safety warning labels may also be provided either on the rear side of the first (resilient) door or behind the resilient door within the housing. Both alternatives are preferred as it ensures that when both doors are closed the warnings are hidden from view, yet must be seen to access the second door. The second door cannot be unlocked when the first door is closed. Of course, the resilient door need not be hinged to the first door as long as it covers the lock for the second door when it is closed.

To improve packaging, the first and second doors may hinge about one or more vertical hinge pins so they each pivot about a respective vertical axis. Of course, horizontal opening is possible.

The flange on the unhinged side of the resilient door may be tapered so that it automatically engages with the inside of the frame when pushed shut, i.e. the end of the U-shaped cross-section may taper slightly inwardly.

A small cut-out may be provided in the top edge of the resilient door into which a finger can be inserted. As the door is pulled at this point, it bows slightly allowing it to open.

In a refinement, a plurality of ridges or grooves extend along the length of the resilient door. These help to detract the eye from any scratches or irregularities on the door allowing a low cost manufacturing process to be employed.

The hinged edge of the resilient door may be formed into a C-shaped channel adapted to clip over a hinge pin secured relative to the second door to form the hinge. The resilient door may therefore be a snap-fit along its hinged edge to the rest of the casing. Again, this results in a simple low cost extrusion to be used. To allow the door to be extruded in lengths, the C-shaped section may be continuous along its length.

According to a second aspect, the invention provides a set of housings for electrical equipment, in which each housing comprises a casing having different external dimensions and incorporating a resilient hinged door of a predetermined width irrespective of the width of the housing.

According to a third aspect, the invention provides a motor controller comprising an electrical circuit accommodated within a housing in accordance with the first aspect of the invention.

Thus, a single width of door can be used in a range of casing sizes. This allows an extrusion process to be used to produce a standard door which fits a range of different size casings.

There will no be described, by way of example only, one embodiment of the present invention with reference to the accompanying drawings of which:
**Figure 1**(a) is a perspective view of a housing for a motor controller for an a.c. inductive motor having two stage entry, both doors shown in the closed position, (b) shows the housing in plan, (c) shows the hinge of one door in detail and (d) shows the detail of the said one door engaging an inner face at one side of the frame of the housing;
**Figure 2** (a) to (d) correspond to Figures 1(a) to (d) but with the resilient door in its open position; and
**Figure 3** (a) to (c) corresponds to Figure 1 with the two doors fully opened for access to the entire housing.

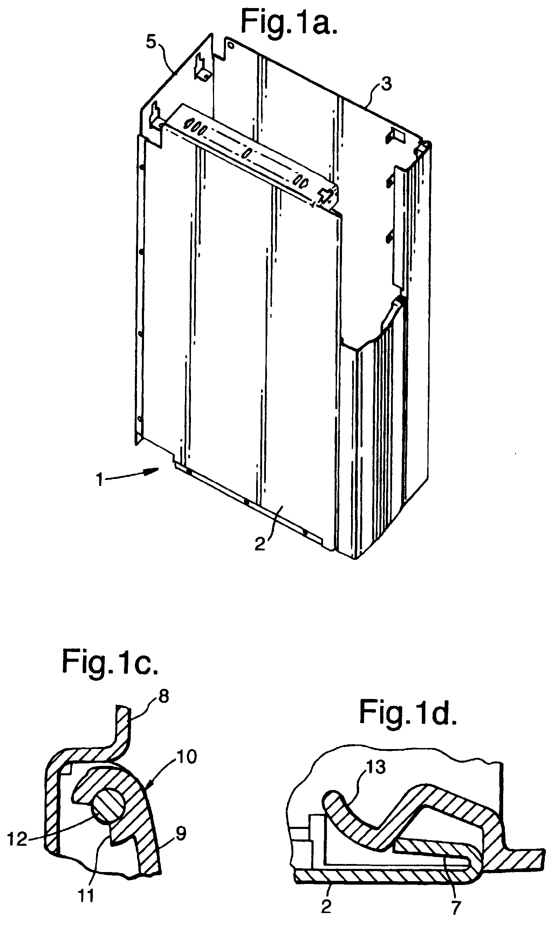

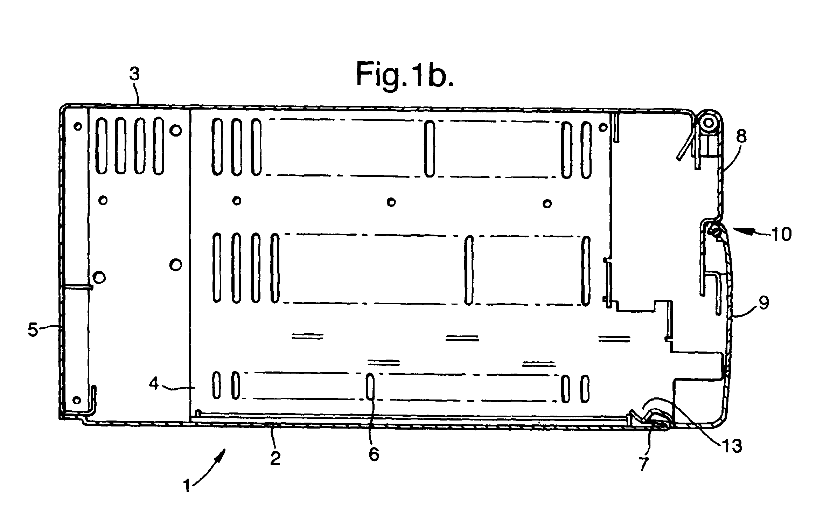

Figures 1 to 3 show a housing 1 in several positions viewed (a) in perspective and (b) from overhead.

The housing comprises a frame formed from pressed steel sheets bolted together at various points along the edges. The frame is shown in the figures with its top panel omitted for clarity and comprises two planar side panels 2, 3 and a base panel 4 and back plate 5. The rear edges of the side panels are secured to the back plate by a number of screws in this example, although rivets could be used instead. The base plate 5 also incorporates slots 6 to allow cooling air to enter the cabinet. The metal frame is tall relative to its width, although the housing may be produced in a range of sizes and shapes suitable, for example, for rack mounting.

The front edge of the left-hand side panel is folded back inside itself to form a smooth leading edge, providing a small flange 7 along its length inside of the panel.

The front of the housing is covered by a two stage door system. This comprises a first metal door 8 hinged along one edge to the right-hand side panel 3 of the frame. The metal door 8 extends along the full height of the frame and is approximately half of the width of the frame.

In its closed position, the metal door 8 is secured to a portion of the base of the frame by a bolt (not shown) engaging a threaded opening in the base. This ensures that access to the right hand side of the casing via the door 8 is only possible using tools.

A second door 9 is hingedly attached along the free edge of the first door furthest from its hinge. This door can be pivoted about its hinged side to gain access to the left-hand side of the casing.

The second door 9 comprises a one-piece plastics extrusion having a substantially uniform cross-section along its length. In practice, a continuous extrusion is produced, and a suitable length portion is cut-off to form the second door.

The extrusion has a substantially U-shaped cross-section, the elongated base of the U forming the front of the door and one side of the section defining a portion of a hinge assembly 10. As shown, this portion is formed into a c-shaped section 11 which clips onto a hinge pin 12 provided on the first door 8.

The other side of the U-shaped extrusion is configured as an extended flange 13 so that it engages with the turned back flange of the left-hand side panel of the frame. This secures the second door 9 in a closed position and prevents accidental release.

Because the second door 9 is resilient, it can be opened by simply deforming the door. This can either be by deforming the flanged side towards the hinged side, or by bowing the base of the U-shaped door or both. Only a light pressure, such as can be applied by hand, is needed to open the door.

The hinged resilient door also incorporates several raised strips or ridges moulded along its length. These help to draw the eye from any defects in the shape of the extrusion, which may occur during production.

In the example, the resilient door 9 is shorter than the first door 8, and extends from the base of the front of the frame only part way towards the top panel. The space above the resilient door provides for the convenient location of a hand-held control pad (not shown) or a bank of control switches.

An important feature of the illustrated embodiment is the two-stage access required to enter the whole casing. In a preferred application, the casing accommodates both low voltage and high voltage electrical circuitry such as that provided in a motor controller for an industrial a.c. induction motor. The low voltage and high voltage circuitry can be conveniently split into two stages: the low voltage circuitry located behind the resilient door and the high voltage behind the locked door.

By opening the resilient door 9, access can be gained to the low voltage components. To access the high voltage components, the resilient door 9 must be open to gain access to the bolt for the door 8. Thus, by providing safety warnings on the inside of the door the user is given the notice required by safety legislation without having unsightly warnings on display in normal use (when the resilient door is closed).

Providing the two doors in parallel, one hinged from the free edge of the other is also advantageous in that it allows a range of widths of casings to be produced using a standard extrusion moulding for the resilient door. For different widths, only the locked door (which can be a simple metal pressing) needs to be of a variable width. Thus, production and trading costs are minimised.

The casing is shown with the doors in various positions in Figures 1 to 3.

In Figure 1, both doors are closed, preventing access to the circuitry within the casing.

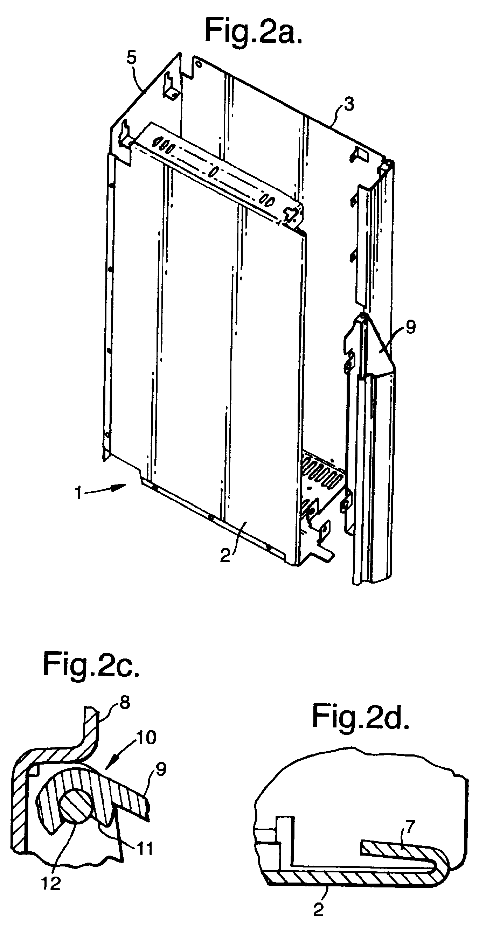

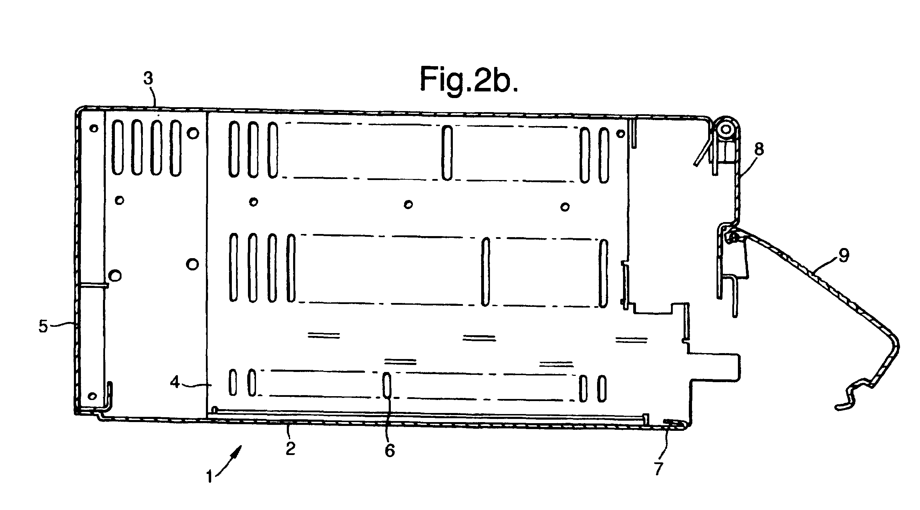

In Figure 2, the resilient door is open whilst the first door is closed. Access to the bolt locking the first door is, how, possible, via the open resilient door.

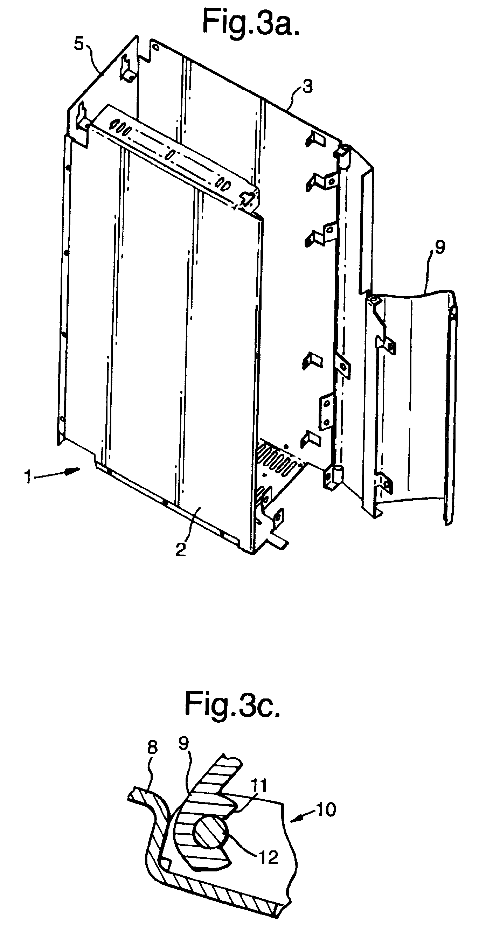

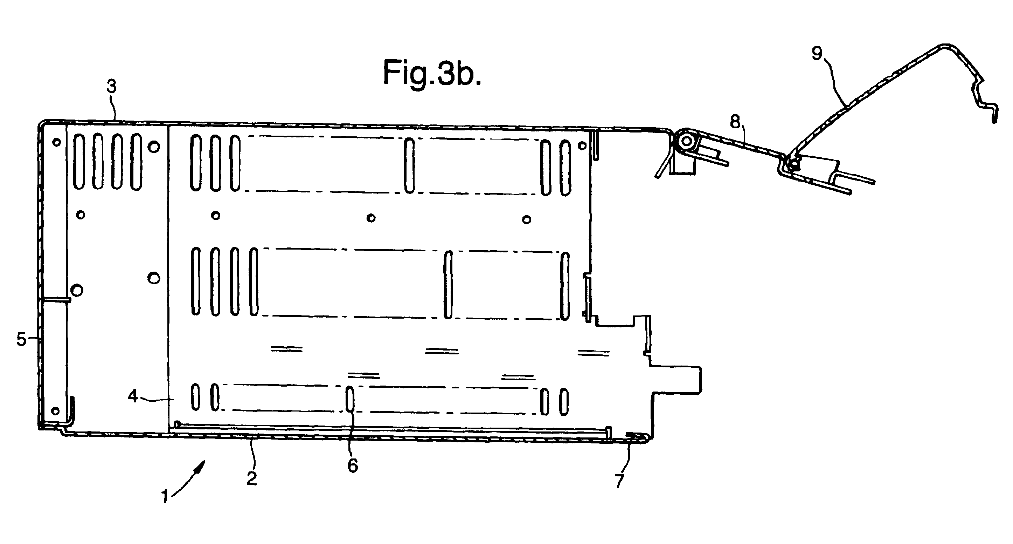

Finally, in Figure 3 both doors are opened giving full access to the inside of the casing.

## Claims

1. A housing (1) for electrical equipment comprising a casing (2, 3, 4, 5) and a door (8) of which at least a part is made of resilient material, the door (18) being adapted to pivot about a hinge along one edge relative to the casing for movement between an open and a closed position, said door (18) being adapted to engage the casing when it is closed position and to be disengaged and moved to an open position by resilient deformation of the door (8) and characterised in that the resilient door (8) is hinged to a second door (9) which in turn is hinged to the frame (2, 3, 4, 5) to provide a two-stage entry.

2. A housing according to claim 1 characterised in that in a first stage, the resilient door (8) is deformed and opened to access a first portion of the housing which contains low voltage equipment.

3. A housing according to claim 1 or claim 2 characterised in that in a second stage, the second door (19) is opened to gain access to a further part of the housing which contains high voltage equipment.

4. A housing according to any one of claims 1, 2 or 3 characterised in that the first door must be opened to gain access to a lock mechanism for the second door (9).

5. A housing according to claim 4 characterised in that warning labels are provided either on the rear side of the first (resilient) door or within the housing behind the resilient door.

6. A housing according to any preceding claim characterised in that the first door (8) comprises a one piece plastics component.

7. A housing according to claim 6 which is characterised in that the door (8) is extruded or otherwise moulded.

8. A housing according to claim 7 characterised in that the door (8) is extruded as a single piece of indefinite length cut to the appropriate length depending on the size of the casing (2, 3, 4, 5) to which it is to be incorporated.

9. A housing according to any preceding claim characterised in that the casing (2, 3, 4, 5) comprises a pressed metal frame formed at least partially from sheet metal.

10. A housing according to any preceding claim characterised in that the frame serves as a chassis for one or more of the electrical components to be held in the frame.

11. A housing according to any preceding claim characterised in that the resilient door (8) has a substantially U-shaped cross section with a substantially flat elongated base portion.

12. A housing according to claim 11 characterised in that one side of the U-shape is adapted to resiliently engage with an inner face of a side wall of the frame.

13. A housing according to claim 12 characterised in that an end of the side wall of the frame is folded back on itself to avoid a sharp edge and a flange formed on the unhinged side of the U-shaped door section engages behind the folded back portion of the frame to hold the door (8) latched in its closed position.

14. A housing according to any preceding claim in which a small cut-out is provided in the top edge of the resilient door (8) into which a finger can be inserted.

15. A housing according to any preceding claim in which a plurality of ridges or grooves extend along the length of the resilient door (8).

16. A housing according to any preceding claim in which the hinged edge of the resilient door (8) is formed into a C-shaped channel adapted to clip over a hinge pin secured relative to the second door to form the hinge.

17. A set of housings for electrical equipment, in which each housing comprises a casing having different external dimensions and incorporating a resilient hinged door of a predetermined width irrespective of the width of the housing.

18. A motor controller comprising an electrical circuit accommodated within a housing in accordance with any one of claims 1 to 16.
